# DEMANDE DE BREVET EUROPEEN

(11) **EP 0 843 351 A1**
(43) Date de publication de la demande: **20.05.1998**
(21) Numéro de dépôt: 97410132.1
(22) Date de dépôt: 18.11.1997
(51) Int. Cl.: H01L 21/331, H01L 29/732

(54) **Procédé de fabrication d'un transistor NPN dans une technologie BICMOS**

(30) Priorité: 19.11.1996 FR 9614411
(71) Demandeur: SGS-THOMSON MICROELECTRONICS S.A., 94250 Gentilly (FR)
(72) Inventeur: Gris, Yvon, 38210 Tullins (FR)
(74) Mandataire: de Beaumont, Michel

(57) **Abrégé**

L'invention concerne un transistor bipolaire de type NPN réalisé dans une couche épitaxiée à l'intérieur d'une fenêtre délimitée dans une couche d'oxyde épais (102), comprenant une ouverture formée sensiblement au centre de ladite fenêtre, cette ouverture pénétrant dans la couche épitaxiée (101) d'une profondeur au moins de l'ordre de grandeur de l'épaisseur de la couche d'oxyde épais, une région dopée de type N (125) au fond de l'ouverture, une première région dopée de type P (114) au fond de l'ouverture, une deuxième région faiblement dopée de type P (115) sur les flancs de l'ouverture, et une troisième région fortement dopée de type P (112) au voisinage de la partie supérieure de l'ouverture, les trois régions de type P étant contiguës et formant la base du transistor.

## Description

La présente invention concerne le domaine des circuits intégrés et plus particulièrement la fabrication d'un transistor NPN.

Dans une demande de brevet déposée le même jour par la demanderesse (N° de référence du mandataire B3221), il est décrit un procédé de fabrication d'un transistor bipolaire compatible avec une technologie BICMOS (c'est-à-dire une technologie permettant la fabrication simultanée de transistors bipolaires et de transistors MOS complémentaires).

Un exemple d'un transistor NPN obtenu dans cette technologie est représenté dans la figure 12A de cette demande de brevet, qui est reproduite à l'identique dans la figure 1 ci-jointe.

Ce transistor NPN est formé dans une couche épitaxiée 2 surmontant une couche enterrée 3 formée dans un substrat de silicium de type P (non représenté). Le transistor est formé dans une fenêtre ménagée dans une couche d'oxyde épais 5. Les références 21 et 22 désignent des couches minces d'oxyde de silicium et de nitrure de silicium inutiles pour la description du transistor bipolaire. La région 23 est une couche de silicium polycristallin dopé de type P dite silicium polycristallin de base puisque c'est à partir de cette couche de silicium qu'est formée la diffusion de contact de base 32. La couche de silicium polycristallin 23 est revêtue d'une couche d'oxyde de silicium d'encapsulation 24. Une ouverture centrale d'émetteur-base est formée dans l'ensemble des couches 22 et 23. Une couche mince d'oxyde de silicium 31 recouvre les flancs de la couche de silicium polycristallin 23 et le fond de l'ouverture. Dans cette ouverture est réalisée une implantation à haute énergie de type N 30 destinée à assurer un niveau choisi de dopage de la région de sous-collecteur. Les parois de l'ouverture d'émetteur-base sont revêtues d'une couche de nitrure de silicium 44. Des espaceurs latéraux en silicium polycristallin 43 sont formés sur les flancs de l'ouverture. Avant formation de la région de nitrure de silicium 44 et des espaceurs de silicium polycristallin 43 est formée une implantation de base intrinsèque 33. Après formation des espaceurs, on dépose une couche 46 de silicium polycristallin fortement dopé de type N à partir de laquelle est formée la diffusion d'émetteur. La couche de silicium polycristallin 46 est revêtue d'une couche d'oxyde d'encapsulation 47. L'ensemble de la structure est revêtu d'une couche d'isolement et de planarisation 51 à travers laquelle sont formées des ouvertures pour le contact d'émetteur 55 rejoignant la couche de silicium polycristallin 46 et de contact de base 56 rejoignant la couche de silicium polycristallin 23. En outre, bien entendu, un contact de collecteur est pris par l'intermédiaire d'une diffusion profonde de type N vers la couche enterrée 3.

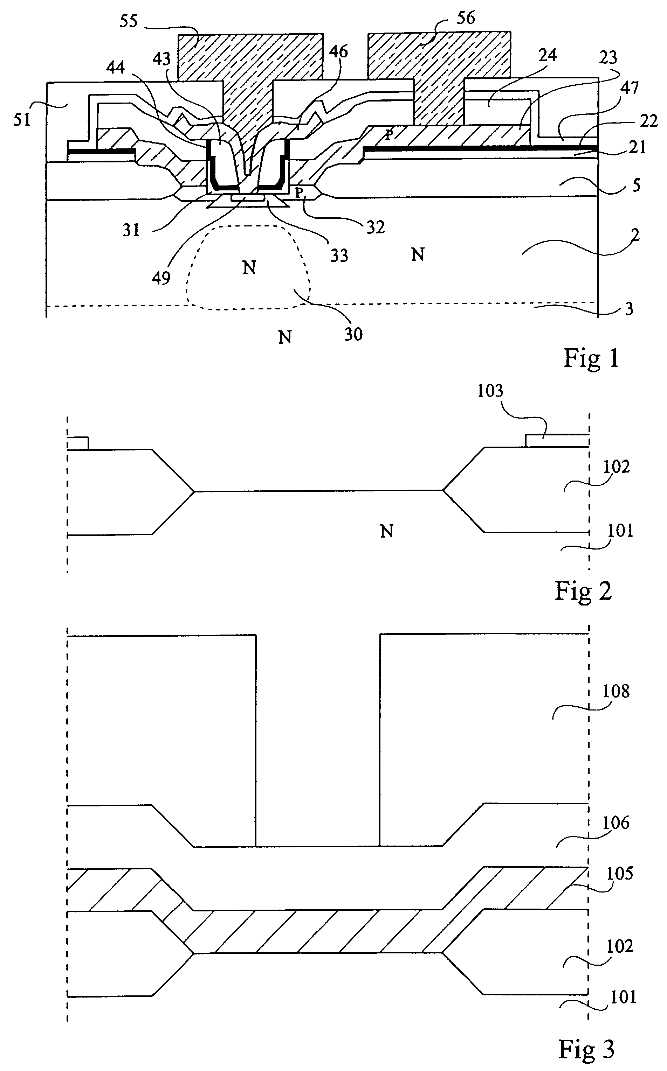

On voit sur la figure 1 que l'ouverture d'émetteur-base pénètre légèrement dans l'épaisseur de la couche épitaxiée 2. Ceci résulte inévitablement du procédé de fabrication et de défauts éventuels de sélectivité de la gravure de la couche de silicium polycristallin 23 par rapport à la gravure du silicium du substrat.

En fait, la profondeur de la pénétration n'est pas contrôlée avec précision et peut par exemple varier de ± 20 nm autour d'une valeur prévue de 30 nm en fonction de légères variations des paramètres de fabrication. Ceci entraîne des caractéristiques variables pour le transistor NPN dont la distance entre la base extrinsèque et la base intrinsèque est variable et donc dont la résistance d'accès à la base fluctue. De plus la surface du fond de l'ouverture - surface de l'émetteur - résulte d'une fin de gravure de silicium polycristallin dopé et risque d'être de mauvaise qualité, ce qui nuit également à la constance des caractéristiques du transistor.

Un objet de la présente invention est de prévoir un transistor NPN du même type que celui de la figure 1 mais dont les paramètres puissent être contrôlés avec précision indépendamment des fluctuations des paramètres de fabrication.

Un autre objet de la présente invention est de prévoir un tel transistor dans lequel la capacité parasite entre la base extrinsèque et le collecteur soit réduite.

Un autre objet de la présente invention est de prévoir un tel transistor dans lequel les capacités parasites et la résistance d'accès à la base soient ajustables.

Pour atteindre ces objets, la présente invention prévoit un transistor de type NPN réalisé dans une couche épitaxiée à l'intérieur d'une fenêtre délimitée dans une couche d'oxyde épais, comprenant une ouverture formée sensiblement au centre de la fenêtre, cette ouverture pénétrant dans la couche épitaxiée d'une profondeur au moins de l'ordre de grandeur de l'épaisseur de la couche d'oxyde épais, les parois de l'ouverture étant revêtues d'une couche d'oxyde de silicium et d'une couche de nitrure de silicium ; un espaceur de silicium polycristallin formé sur les parois latérales et une portion de la paroi de fond de l'ouverture ; une couche de silicium polycristallin fortement dopé de type N formée dans l'ouverture et en contact avec la couche épitaxiée au fond de l'ouverture à l'intérieur de l'espace délimité par l'espaceur ; une région dopée de type N au fond de l'ouverture ; une première région de base dopée de type P au fond de l'ouverture ; une deuxième région faiblement dopée de type P sur les flancs de l'ouverture ; et une troisième région fortement dopée de type P formée au voisinage de la partie supérieure de l'ouverture, cette troisième région étant en contact avec une couche de silicium polycristallin dopée de type N, les trois régions de type P étant contiguës et formant la base du transistor.

Selon un mode de réalisation de la présente invention, le transistor comprend en outre une quatrième région dopée de type P intermédiaire entre les troisième et deuxième régions.

Selon un mode de réalisation de la présente invention, le collecteur est constitué verticalement d'une portion de la couche épitaxiée, d'une région surdopée résultant d'une implantation dans ladite ouverture et d'une couche enterrée.

La présente invention prévoit aussi un procédé de fabrication d'un transistor NPN dans une couche épitaxiée de type N, comprenant les étapes consistant à délimiter une fenêtre dans une couche d'oxyde épais ; déposer une couche de silicium polycristallin et une couche d'oxyde de silicium ; ouvrir sensiblement au centre de la fenêtre les couches d'oxyde de silicium et de silicium polycristallin ; procéder à une oxydation thermique ; former dans l'ouverture une couche d'un premier matériau isolante et sélectivement gravable par rapport à l'oxyde de silicium ; former des espaceurs en un deuxième matériau sélectivement gravable par rapport à l'oxyde de silicium et au premier matériau ; ouvrir le fond de l'ouverture à l'intérieur de la zone délimitée par les espaceurs ; déposer une couche de silicium polycristallin dopé de type N ; et après l'étape d'ouverture des couches de silicium polycristallin et d'oxyde de silicium, l'étape consistant à ouvrir en outre sur une profondeur déterminée la couche épitaxiée et à implanter un dopant de type P dans la couche épitaxiée au fond de l'ouverture et sur les parois de celle-ci.

Selon un mode de réalisation de la présente invention, l'étape d'implantation est une étape d'implantation oblique sous faible incidence.

Selon un mode de réalisation de la présente invention, le procédé comprend en outre une deuxième étape d'implantation oblique sous forte incidence et à forte dose d'un dopant de type P.

Selon un mode de réalisation de la présente invention, le procédé comprend, après l'étape de formation d'une ouverture dans la couche épitaxiée, l'étape d'implantation d'un dopant de type N pour former dans la couche épitaxiée une région de collecteur de type N à plus fort niveau de dopage proche d'une couche enterrée de type N⁺ formée sous cette couche épitaxiée.

Selon un mode de réalisation de la présente invention, le premier matériau est du nitrure de silicium.

Selon un mode de réalisation de la présente invention, le deuxième matériau est du silicium polycristallin.

La présente invention vise aussi un transistor obtenu par ce procédé.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un transistor NPN fabriqué par un procédé décrit dans une demande de brevet déposée le même jour que la présente demande ;
les figures 2 à 7 représentent des étapes successives de fabrication d'un transistor selon la présente invention ; et
la figure 8 représente une courbe de concentration de dopant en fonction de la profondeur.

La figure 2 représente une étape initiale de fabrication d'un transistor bipolaire de type NPN selon la présente invention. Sur une couche épitaxiée de type N 101, une fenêtre est délimitée dans une couche d'oxyde épais 102. On a également représenté, à titre d'exemple, une couche 103 ouverte plus largement que la fenêtre 102 et qui a pu servir dans une phase antérieure de protection de cette fenêtre pendant la réalisation d'autres étapes. La couche 103 est par exemple une couche d'oxyde de silicium d'une épaisseur de 20 à 30 nanomètres recouverte d'une couche de nitrure de silicium également d'une épaisseur de 20 à 30 nanomètres. Cette couche 103 ne sera pas représentée dans la suite des figures étant donné qu'elle ne joue pas de rôle fonctionnel dans le transistor bipolaire qui va être décrit.

A l'étape illustrée en figure 3, on dépose successivement une couche de silicium polycristallin 105 fortement dopé de type P, par exemple par implantation après dépôt (typiquement du BF2 à une dose de 5 10¹⁵ sous 20 keV), une couche d'oxyde de silicium 106 et une couche de résine de masquage 108.

A titre d'exemple de valeurs numériques, dans un mode de réalisation adapté à la fabrication de circuits intégrés submicroniques, l'épaisseur de la couche d'oxyde épais 102 pourra être de l'ordre de 500 nm, l'épaisseur de la couche de silicium polycristallin 105 de l'ordre de 200 nm, l'épaisseur de la couche d'oxyde de silicium 106 de l'ordre de 300 nm, et l'épaisseur de la couche de résine 108 de l'ordre de 1000 nm (1 µm).

Ensuite, on ouvre par photolithographie une ouverture dans la couche de masquage 108. Cette ouverture est disposée de façon sensiblement centrale dans la fenêtre formée dans la couche d'oxyde épais 102. Si la fenêtre dans la couche d'oxyde épais 102 a une largeur de l'ordre de 1200 nm, l'ouverture dans la couche de résine a une largeur de l'ordre de 400 à 800 nm, par exemple 600 nm.

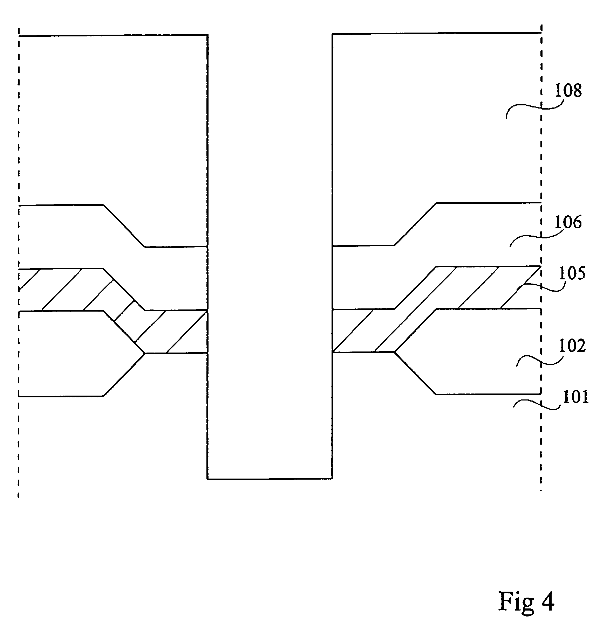

A l'étape illustrée en figure 4, on a procédé à des gravures plasma anisotropes successives des couches d'oxyde de silicium 106 et de silicium polycristallin 105.

Selon un aspect de la présente invention, on procède aussi à une gravure anisotrope du silicium monocristallin de la couche épitaxiée 101. Cette gravure est poursuivie pendant une durée déterminée pour atteindre une profondeur choisie de pénétration dans le silicium. Cette profondeur sera par exemple de l'ordre de 300 à 1000 nm, par exemple 600 nm. On notera que cette profondeur est loin d'être négligeable et est de l'ordre de grandeur de l'épaisseur de la couche d'oxyde épais 102 (500 nn). Comme on le verra ci-après, le choix de cette profondeur permet de sélectionner des caractéristiques souhaitées pour le transistor NPN.

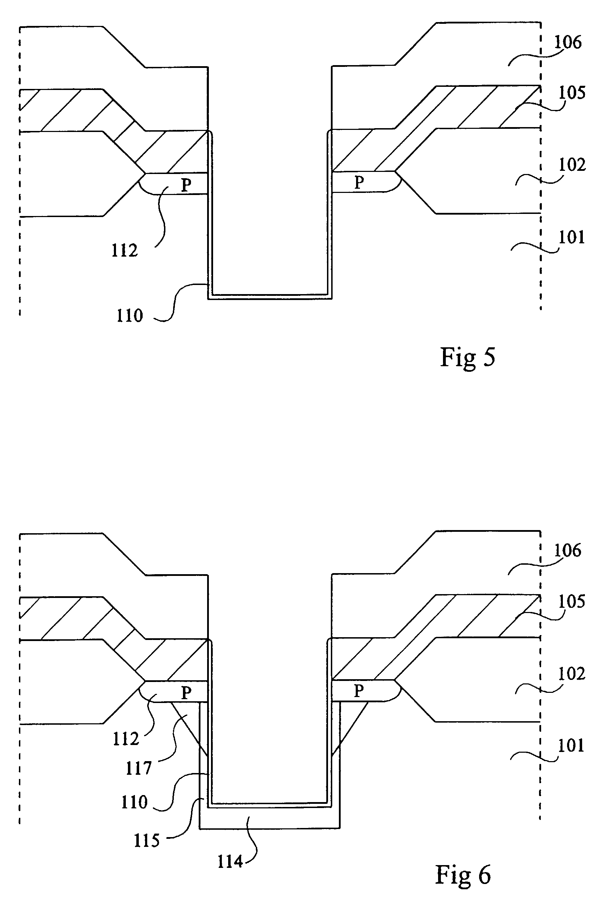

A l'étape illustrée en figure 5, on élimine la couche de résine 108 et l'on procède à un recuit oxydant pour développer une couche d'oxyde de silicium 110 à l'intérieur de l'ouverture formée précédemment. Cette couche se développe sur les faces apparentes du silicium monocristallin 101 et du silicium polycristallin 105. Pour atteindre une épaisseur d'oxyde de l'ordre de 5 nm, on pourra procéder à un recuit en présence d'oxygène à une température de 850 à 900°C pendant un quart d'heure. Pendant cette étape de recuit, le bore ou autre dopant de type P contenu dans le silicium polycristallin 105 diffuse dans le silicium sous-jacent pour former une région de contact de base 112, de type P, dont la profondeur de jonction est par exemple de l'ordre de 100 nm.

A l'étape suivante illustrée en figure 6, on procède à deux implantations successives d'un dopant de type P.

La première implantation est réalisée sous incidence oblique d'un angle de 1 à 10° tandis que la plaquette tourne par rapport à l'axe d'implantation. On obtient ainsi une zone dopée qui, après recuit, a l'allure illustrée dans la figure, et comprend une zone implantée plus profonde 114 au fond de l'ouverture et une zone implantée moins profonde 115 sur les flancs de l'ouverture. Cette première implantation est par exemple une implantation de bore réalisée sous 5 keV avec une dose de 2.10¹³ atomes/cm².

La deuxième implantation est également réalisée sous incidence oblique, tandis que la plaquette est entraînée en rotation, mais avec un angle d'incidence plus important que précédemment, de 30 à 50°, par exemple 45°, pour implanter un dopant seulement dans une partie supérieure des flancs de l'ouverture formée dans la couche épitaxiée 101. On obtient ainsi une région implantée 117 dont le niveau de dopage est intermédiaire entre le niveau de dopage des régions 114-115 et celui de la région 112. Cette deuxième implantation est par exemple une implantation réalisée à partir d'un fluorure de bore (BF₂) sous forte énergie (45 kev) et avec une dose relativement élevée, par exemple 10¹⁴ atomes/cm².

La réalisation de cette deuxième implantation, bien que constituant un mode de réalisation préféré de l'invention, est facultative.

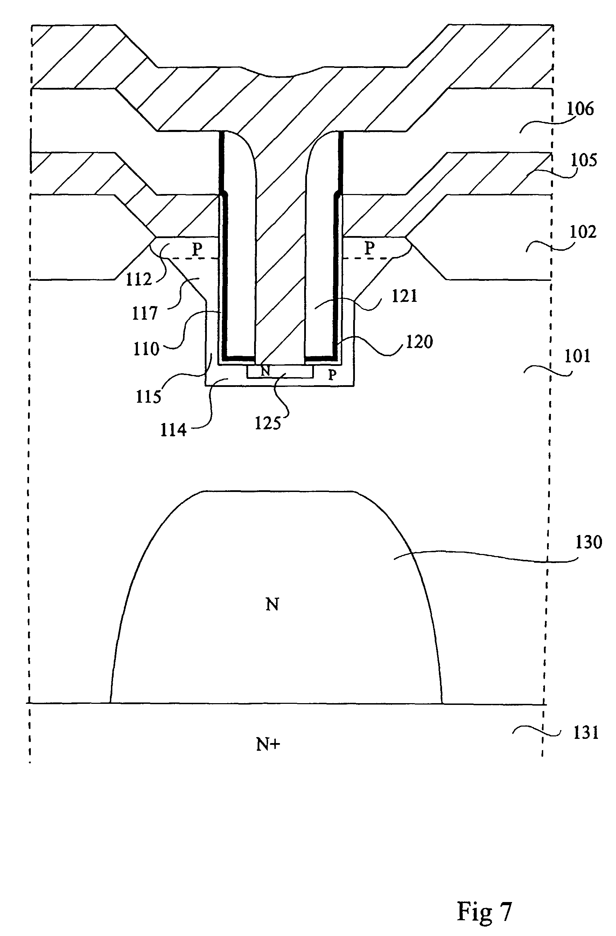

La figure 7 représente la structure selon la présente invention à une étape pratiquement finale de fabrication. On a d'abord déposé sur toute la surface du dispositif, et notamment à l'intérieur de l'ouverture, une couche de nitrure de silicium 120, puis une couche de silicium polycristallin 121. La couche de silicium polycristallin a été gravée, comme le représente la figure, pour ne laisser en place que des espaceurs le long des parois de l'ouverture. Ensuite, les parties de la couche de nitrure de silicium non protégées par les espaceurs 121 sont éliminées. Après cela, on élimine la portion apparente de la couche d'oxyde de silicium thermique 110 au fond de l'ouverture et on dépose une couche de silicium polycristallin 123 fortement dopé in situ de type N. On procède alors à un recuit thermique pour faire diffuser au fond de l'ouverture une région 125 dopée de type N constituant l'émetteur du transistor bipolaire.

On a également représenté en figure 7 la partie de collecteur du transistor bipolaire selon l'invention qui n'avait pas été représentée dans les figures 2 à 6. Cette partie de collecteur correspond à une partie de la couche épitaxiée 101 située sous l'ouverture d'émetteur-base et comporte plus particulièrement une région 130 formée par implantation à partir de l'ouverture immédiatement après l'étape illustrée en figure 4 (avant enlèvement de la couche de résine 108) et se développant au-dessus d'une couche enterrée de type N⁺ 131 (elle-même formée sur une plaquette de silicium de type P, non représentée). On obtient ainsi une région de collecteur 130 bien localisée latéralement et en profondeur sous la région d'émetteur 125 et la région de base intrinsèque 114.

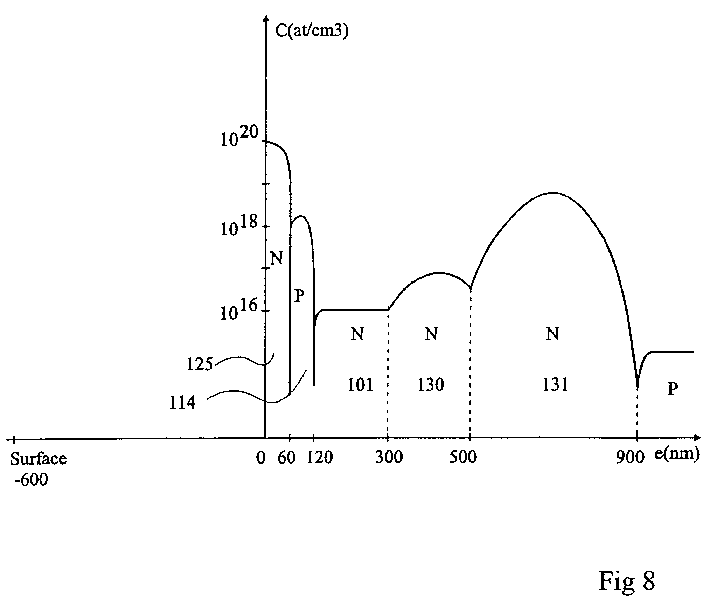

La figure 8 représente un exemple de concentration de dopants que l'on peut obtenir selon la présente invention dans une coupe prise selon l'axe de l'ouverture d'émetteur-base. On y trouve successivement :
- la région d'émetteur 125, dont la concentration en surface est de l'ordre de 10²⁰ at./cm³,
- la région de base intrinsèque 114, dont la concentration à la jonction est de l'ordre de quelques 10¹⁸ at./cm³,
- une portion de la couche épitaxiée 101, dont le niveau de dopage est de l'ordre de 10¹⁶ at./cm³,
- la région 130, dont le niveau de dopage maximum est de l'ordre de 10¹⁷ at./cm³,
- la couche enterrée 131, dont le niveau de dopage maximum est de l'ordre de 10¹⁹ at./cm³, et
- le substrat de type P sur lequel est formée la structure, dont le niveau de dopage est par exemple de l'ordre de 10¹⁵ at./cm³.

Dans l'hypothèse où l'épaisseur de la couche épitaxiée est de l'ordre de 1,4 µm (1400 nm) et où le fond de l'ouverture est à 600 nm de la surface, l'épaisseur de la région 125 pourra être de l'ordre de 60 nm, l'épaisseur totale de la région 114 sous le fond de l'ouverture de l'ordre de 120 nm, l'épaisseur de la région épitaxiée exempte de surdopage de l'ordre de 200 nm, et l'épaisseur de la région de collecteur à dopage adapté 130 de l'ordre de 200 nm.

Une caractéristique essentielle de la présente invention est de prévoir une ouverture de profondeur non négligeable dans la couche épitaxiée 101 et de prévoir divers niveaux de dopage de base autour et au fond de cette ouverture. Ainsi, le niveau de dopage de la région de base intrinsèque 114 peut être réglé de façon souhaitée et la résistance de base extrinsèque comprenant les régions 115 et 117 vers la région de contact de base 112 peut être ajustée de façon souhaitée dans le but d'optimiser la résistance de base, de réduire les capacités base-émetteur et base-collecteur, et d'améliorer les caractéristiques inverses de la jonction émetteur-base. En effet, ces capacités base-émetteur et base-collecteur dépendent essentiellement de la distance entre la partie la plus dopée 112 et la région d'émetteur 114 d'une part, et les régions plus dopées de collecteur 130 d'autre part. On pourra ajuster la profondeur de l'ouverture et les niveaux de dopage de base en fonction des résultats recherchés.

Bien entendu, la présente invention est susceptible de nombreuses variantes de réalisation qui apparaîtront à l'homme de métier. Notamment, les reprises de contact de base, d'émetteur et de collecteur n'ont pas été décrites mais pourront être réalisées de la façon décrite en relation avec la figure 1.

Pour éviter tout risque de court-circuit entre les régions de silicium polycristallin de base 105 et de silicium polycristallin d'émetteur 123, on peut prévoir le dépôt d'une couche de nitrure de silicium à l'interface entre la couche de silicium polycristallin 105 et la couche d'oxyde de silicium 106. Le bord apparent, du côté de l'ouverture de cette couche de nitrure de silicium supplémentaire, se soudera avec la couche de nitrure de silicium 120 lors du dépôt de celle-ci. On évite ainsi tout risque de pénétration d'agent de gravure ou toute gravure lors d'une gravure plasma à l'interface entre les bords de la couche d'oxyde de silicium 106 et la paroi externe de la couche de nitrure de silicium 120.

Diverses valeurs numériques ont été indiquées à titre d'exemple, pour faire comprendre que l'invention s'applique à des structures de très petites dimensions mais l'invention s'applique de façon plus générale à la réalisation de transistors NPN de dimensions différentes dans lesquels on cherche à optimiser les résistances et capacités parasites. De même, on a indiqué à titre d'exemple l'utilisation de dopant et de modes d'implantation particuliers. L'homme de l'art pourra utiliser diverses variantes connues pour la mise en oeuvre des dopages.

Diverses variantes de matériaux pourront également être effectuées. Par exemple d'autres matériaux pourront être utilisés pour la couche de nitrure de silicium 120 et la couche de silicium polycristallin 121. Il faut seulement que ces deux matériaux puissent être gravés sélectivement l'un par rapport à l'autre et par rapport à l'oxyde de silicium, et que le deuxième matériau puisse être gravé de façon à former des espaceurs.

## Revendications

1. Transistor bipolaire de type NPN réalisé dans une couche épitaxiée à l'intérieur d'une fenêtre délimitée dans une couche d'oxyde épais (102), comprenant :
une ouverture formée sensiblement au centre de ladite fenêtre, cette ouverture pénétrant dans la couche épitaxiée (101) d'une profondeur au moins de l'ordre de grandeur de l'épaisseur de la couche d'oxyde épais, les parois de l'ouverture étant revêtues d'une couche d'oxyde de silicium (110) et d'une couche de nitrure de silicium (120),
un espaceur de silicium polycristallin (121) formé sur les parois latérales et une portion de la paroi de fond de l'ouverture,
une couche de silicium polycristallin fortement dopé de type N (123) formée dans l'ouverture et en contact avec la couche épitaxiée au fond de l'ouverture à l'intérieur de l'espace délimité par l'espaceur (121),
une région dopée de type N (125) au fond de l'ouverture,
une première région de base dopée de type P (114) au fond de l'ouverture,
une deuxième région faiblement dopée de type P (115) sur les flancs de l'ouverture, et
une troisième région fortement dopée de type P (112) formée au voisinage de la partie supérieure de l'ouverture, cette troisième région étant en contact avec une couche de silicium polycristallin dopée de type N (105), les trois régions de type P étant contiguës et formant la base du transistor.

2. Transistor NPN selon la revendication 1, caractérisé en ce qu'il comprend en outre une quatrième région dopée de type P (117) intermédiaire entre les troisième (112) et deuxième (115) régions.

3. Transistor NPN selon la revendication 1 ou 2, caractérisé en ce que son collecteur est constitué verticalement d'une portion de la couche épitaxiée (101), d'une région surdopée résultant d'une implantation (130) dans ladite ouverture et d'une couche enterrée.

4. Procédé de fabrication d'un transistor NPN dans une couche épitaxiée de type N, comprenant les étapes suivantes :
délimiter une fenêtre dans une couche d'oxyde épais (102),
déposer une couche de silicium polycristallin (105) et une couche d'oxyde de silicium (106),
ouvrir sensiblement au centre de ladite fenêtre les couches d'oxyde de silicium (106) et de silicium polycristallin (105),
procéder à une oxydation thermique,
former dans l'ouverture une couche d'un premier matériau (120) isolante et sélectivement gravable par rapport à l'oxyde de silicium,
former des espaceurs en un deuxième matériau (121) sélectivement gravable par rapport à l'oxyde de silicium et au premier matériau,
ouvrir le fond de l'ouverture à l'intérieur de la zone délimitée par les espaceurs,
déposer une couche de silicium polycristallin (123) dopé de type N,
caractérisé en ce qu'il comprend, après l'étape d'ouverture des couches de silicium polycristallin (105) et d'oxyde de silicium (106), l'étape consistant à ouvrir en outre sur une profondeur déterminée la couche épitaxiée (101) et à implanter un dopant de type P dans la couche épitaxiée au fond de l'ouverture et sur les parois de celle-ci.

5. Procédé selon la revendication 4, caractérisé en ce que l'étape d'implantation est une étape d'implantation oblique sous faible incidence.

6. Procédé selon la revendication 5, caractérisé en ce qu'il comprend en outre une deuxième étape d'implantation oblique sous forte incidence et à forte dose d'un dopant de type P.

7. Procédé selon quelconque des revendications 4 à 6, caractérisé en ce que, après l'étape de formation d'une ouverture dans la couche épitaxiée, il comprend l'étape d'implantation d'un dopant de type N pour former dans la couche épitaxiée une région de collecteur de type N à plus fort niveau de dopage proche d'une couche enterrée de type N⁺ formée sous cette couche épitaxiée.

8. Procédé selon la revendication 4, caractérisé en ce que le premier matériau (120) est du nitrure de silicium.

9. Procédé selon la revendication 4, caractérisé en ce que le deuxième matériau (121) est du silicium polycristallin.
